(19) **Europäisches Patentamt / European Patent Office / Office européen des brevets**

(11) **EP 1 616 159 B1**

(12) **FASCICULE DE BREVET EUROPEEN**

(45) Date de publication et mention
de la délivrance du brevet:
**04.03.2009 Bulletin 2009/10**

(21) Numéro de dépôt: **04742523.6**

(22) Date de dépôt: **16.04.2004**

(51) Int Cl.:
*G01J 5/10* (2006.01)     *G01J 5/20* (2006.01)
*B81B 1/00* (2006.01)     *B81B 3/00* (2006.01)

(86) Numéro de dépôt international:
**PCT/FR2004/000942**

(87) Numéro de publication internationale:
**WO 2004/097355 (11.11.2004 Gazette 2004/46)**

(54) **DETECTEUR THERMIQUE DE RAYONNEMENT ELECTROMAGNETIQUE A STRUCTURE ALVEOLEE**

THERMISCHER DETEKTOR MIT WABENFÖRMIGER STRUKTUR FÜR ELEKTROMAGNETISCHE STRAHLUNG

HONEYCOMB-STRUCTURED ELECTROMAGNETIC RADIATION THERMAL DETECTOR

(84) Etats contractants désignés:
**AT BE BG CH CY CZ DE DK EE ES FI FR GB GR HU IE IT LI LU MC NL PL PT RO SE SI SK TR**

(30) Priorité: **24.04.2003 FR 0305030**

(43) Date de publication de la demande:
**18.01.2006 Bulletin 2006/03**

(73) Titulaire: **COMMISSARIAT A L'ENERGIE ATOMIQUE**
**75752 Paris Cédex 15 (FR)**

(72) Inventeurs:
• **YON, Jean-Jacques**
**F-38360 Sassenage (FR)**

• **OUVRIER-BUFFET, Jean-Louis**
**F-74320 Sévrier (FR)**
• **ASTIER, Astrid**
**F-38340 Voreppe (FR)**
• **VILAIN, Michel**
**F-38450 Saint-Georges De Commiers (FR)**

(74) Mandataire: **Jouvray, Marie-Andrée et al**
**Cabinet Hecké,**
**World Trade Center - Europole,**
**5, place Robert Schuman,**
**B.P. 1537**
**38025 Grenoble Cedex 1 (FR)**

(56) Documents cités:
**WO-A-03/011747**     **US-A- 5 990 481**
**US-A- 6 094 127**     **US-B1- 6 506 621**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

## Domaine technique de l'invention

L'invention concerne un détecteur thermique de rayonnement électromagnétique comportant une membrane absorbante fixée en suspension sur une face avant d'un substrat, sensiblement parallèlement au substrat; par des moyens de support isolant thermiquement la membrane du substrat.

## État de la technique

Les avancées techniques récentes de la micro électronique du silicium et de la réalisation de couches minces ont donné un nouvel essor à la technologie des détecteurs thermiques de rayonnement infrarouge comportant une membrane absorbante fixée en suspension sur un substrat par des moyens de support.

Par ailleurs, la micro-électronique repose sur des procédés collectifs, réalisés au niveau de la plaquette de silicium, dont peuvent aussi profiter les technologies des détecteurs thermiques à de nombreux titres. Ces techniques collectives ouvrent en effet la possibilité de réaliser des matrices de détecteurs de grande complexité, typiquement des matrices de 320x240 détecteurs, et également de réaliser un grand nombre de matrices sur une seule plaquette de silicium et donc de réduire le coût de fabrication unitaire des détecteurs. Cette propriété, associée au fait que les détecteurs thermiques peuvent fonctionner à température ambiante et s'affranchir de tout système de refroidissement, fait que cette technologie est particulièrement bien adaptée à la réalisation de systèmes d'imagerie infrarouge faible coût.

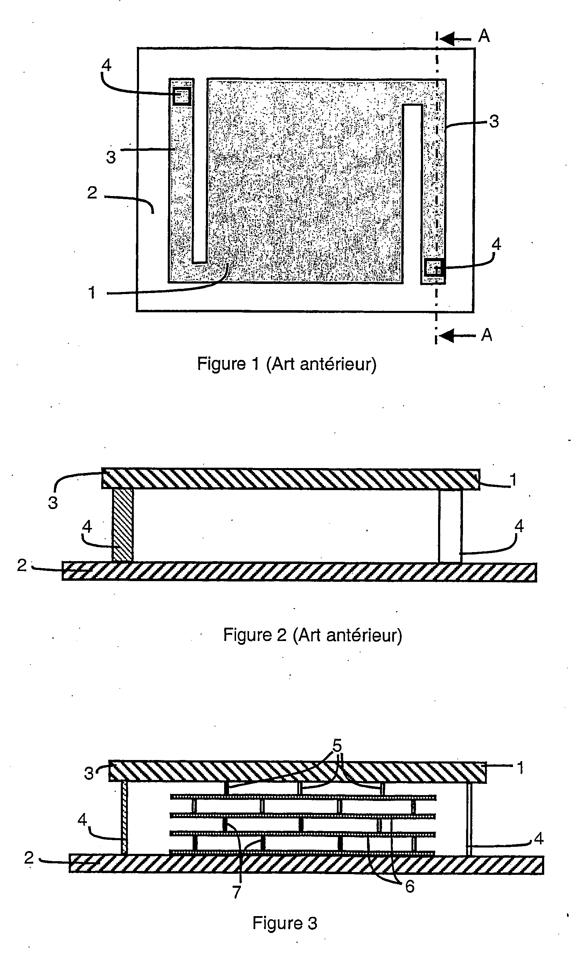

Les figures 1 et 2 montrent une membrane 1, absorbante vis-à-vis du rayonnement électromagnétique incident, d'un détecteur thermique, maintenue en suspension sensiblement parallèlement à un substrat 2, par des moyens de support comportant deux bras 3 d'isolation thermique, solidaires de la membrane 1 et disposés sensiblement dans le plan de la membrane 1. Les bras 3 sont fixés chacun au substrat 2 par l'intermédiaire de piliers 4 dimensionnés pour supporter la masse de la membrane. Sous l'effet du rayonnement, la membrane s'échauffe et transmet sa température à un thermomètre disposé sur la membrane, par exemple un thermistor sous forme d'une couche mince déposée sur la membrane.

Le substrat 2 peut être constitué par un circuit électronique intégré sur une plaquette de silicium comprenant, d'une part, les dispositifs de stimuli et de lecture du thermomètre et, d'autre part, des composants de multiplexage qui permettent de sérialiser les signaux issus de différents thermomètres et de les transmettre vers un nombre réduit de sorties afin d'être exploités par un système d'imagerie usuel. Afin d'améliorer la sensibilité du détecteur thermique, les moyens de support sont conçus de manière à isoler thermiquement la membrane 1 absorbante du substrat 2, permettant ainsi de limiter les pertes thermiques de la membrane et, par conséquent, de préserver son échauffement.

L'interconnexion électrique entre le thermomètre et les éléments de lecture disposés sur le substrat 2 est généralement assurée par une couche métallique disposée sur les moyens de support.

Une analyse simplifiée de l'échauffement ($\Theta$) de la membrane sous l'effet de la puissance effectivement absorbée ( $P_{abs}(t)$ ) du rayonnement incident peut être réalisée, a priori, sans hypothèse particulière sur la nature du thermomètre. Le bilan de l'échauffement, dépendant de la conductance thermique $G_{th}$ des moyens de support, représentant les pertes thermiques, et de la capacité thermique $C_{th}$ de la membrane, représentant l'inertie thermique, peut être exprimé approximativement par l'équation différentielle suivante ;

$$ C_{th}\frac{d\Theta}{dt} + G_{th}\Theta = P_{abs}(t) \ . $$

Cette équation trouve comme solution particulière, pour une puissance de rayonnement modulé de manière sinusoïdale à la pulsation $\omega$, l'expression :

$$ \Theta = \frac{\hat{P}_{abs}(t)}{G_{th}\sqrt{1+\omega^2\tau^2}}, $$

où $\tau$ représente la constante de temps thermique de la membrane définie par $\tau = C_{th}/G_{th}$.

Les variations de température de la membrane suivent les variations de puissance du rayonnement incident. Aux fréquences faibles, c'est-à-dire $\omega\tau<<1$, l'amplitude de l'élévation de température, qui définit le signal délivré par le détecteur, est inversement proportionnelle à $G_{th}$ :

$$ \Theta = \frac{P_{abs}}{G_{th}}. $$

Aux fréquences élevées, c'est-à-dire $\omega>>1$ , le signal du détecteur décroît comme l'inverse de la fréquence de modulation. Cette réduction de sensibilité aux fréquences élevées est d'autant plus marquée que $C_{th}$ est grand :

$$ \Theta = \frac{P_{abs}}{\omega C_{th}}. $$

La transition entre ces deux régimes est caractérisée par la constante de temps thermique τ.

Il ressort de cette analyse que les caractéristiques fondamentales qui définissent la performance du détecteur thermique sont la conductance thermique $G_{th}$ et la capacité thermique $C_{th}$, que l'on cherche à minimiser afin d'optimiser la sensibilité du détecteur. Par conséquent, des matériaux à faible conductivité thermique sont utilisés pour les moyens de support, et des matériaux de faible chaleur massique sont utilisés pour la membrane absorbante. De plus, la membrane présente généralement une faible épaisseur.

Afin de minimiser la conductance thermique des moyens de support, l'espace entre la membrane 1 et le substrat 2 (figures 1 et 2) est évacué d'air ou rempli de gaz de faible conductivité thermique. De plus, les bras 3 solidaires de la membrane 1 présentent souvent une longueur maximale, compatible avec d'autres contraintes. Dans le cas de bras d'isolation thermique simples, représentés à la figure 1, la longueur maximale correspond sensiblement à la dimension de la membrane. Un développement de cette technique consiste à fabriquer des bras d'isolation thermique repliés sur eux-mêmes, en forme de serpentin, présentant ainsi une longueur correspondant à un multiple de la dimension de la membrane. L'inconvénient de cette technique est qu'elle restreint la surface de la membrane absorbante et ainsi la surface effective du détecteur.

Le document US 6 144 030 divulgue un microbolomètre comportant des bras d'isolation thermique repliés sur eux-mêmes et disposés entre la membrane et le substrat, ce qui permet de conserver la surface effective tout en allongeant les bras d'isolation thermique constituant les moyens de support. Cependant, cette construction présente plusieurs inconvénients :

- Le maintien mécanique des bras en forme de serpentin, maintenu en porte-à-faux par un point d'ancrage positionné à l'extrémité du serpentin, requiert une augmentation de l'épaisseur des bras et, ainsi, une augmentation de la conductance thermique.
- Cette construction est mal adaptée à la réalisation de cavités interférentielles, couramment utilisées pour optimiser l'absorption du rayonnement. En effet, les cavités interférentielles les plus performantes sont usuellement réalisées en positionnant une couche métallique réfléchissante, de quelques centaines de nanomètres d'épaisseur, sur le substrat. Cette couche réfléchissante constitue, en conjonction avec la membrane, une lame quart d'onde centrée sur la longueur d'onde à détecter. Les bras disposés entre la membrane et le substrat constituent un élément perturbateur critiquable. Pour pallier cette difficulté, il est proposé de positionner la couche réfléchissante sur les moyens de support, notamment sur les bras. Cependant, les matériaux réfléchissant l'infrarouge se caractérisent par de très fortes conductivités thermiques préjudiciables à une bonne isolation thermique.

- Cette construction conduit à un accroissement de la masse suspendue, d'autant plus si l'on retient l'option de positionner une couche réfléchissante sur les moyens de support. Cette augmentation de masse augmente la constante de temps thermique et la vulnérabilité du détecteur aux agressions mécaniques, par exemple des chocs et des vibrations.
- Enfin, cette construction nécessite, en plus des moyens de fixation des bras au substrat, des moyens de fixations de la membrane aux bras, permettant l'interconnexion électrique d'un thermomètre. Ceci se traduit par un accroissement de la complexité de la technologie de réalisation.

Une autre voie de minimisation de la conductance thermique consiste à réduire la section des bras d'isolation thermique ou, plus généralement, des moyens de support. Cependant, des sections trop faibles détériorent la solidité mécanique du détecteur et peuvent mener à un fléchissement des moyens de support, entraînant un basculement de la membrane jusqu'au contact avec le substrat, court-circuitant ainsi l'isolation thermique.

Le basculement peut être empêché par l'adjonction d'une connexion mécanique qui relie deux membranes adjacentes entre elles. L'inconvénient de cette connexion mécanique réside dans le couplage thermique entre les deux membranes, ce qui conduit à une dégradation de la résolution spatiale du dispositif. Un autre moyen pour empêcher le basculement consiste à augmenter le nombre de points d'ancrage des moyens de support sur le substrat, cependant ceci augmente la conductance thermique.

En général, l'optimisation des détecteurs thermiques de rayonnement se heurte à un compromis qui met en balance, d'un côté la longueur des moyens de support et d'un autre côté leur section, compromis arbitré par leur tenue mécanique.

Le document WO 03011747 décrit un capteur de gaz comportant une membrane suspendue reliée à un substrat au moyen de ponts et de cantilevers en silicium poreux. Les ponts et cantilevers sont disposés dans le même plan (horizontal) que la membrane suspendue. Ils sont directement formés, dans ce plan, dans le substrat dont les parties correspondant aux ponts, aux cantilevers et à la membrane sont rendues poreuses. Une cavité est ensuite creusée sous la membrane et sous les ponts et les cantilevers.

Par ailleurs, le document US 5 656 848 décrit un détecteur thermique sous la forme d'une matrice de détection comportant des pixels et captant le rayonnement infrarouge.

Le détecteur est un détecteur pyroélectrique ne comportant pas de partie suspendue et réalisé par un empilement de couches et une hybridation par pressage d'un matériau fusible. Il décrit l'utilisation d'un matériau poreux comme matériau de remplissage. Cependant, la technologie décrite dans le document ne peut pas s'appliquer à un détecteur du type bolomètre comportant une membrane suspendue au-dessus d'une cavité, sinon à remplir l'espace sous la membrane entraînant alors l'écrasement de l'empilement bolométrlque et une très mauvaise isolation thermique.

**Objet de l'invention**

L'invention a pour but de remédier à ces inconvénients et, en particulier, de réaliser un détecteur, comportant une membrane absorbante et des moyens de support, présentant un fort pouvoir d'isolation thermique tout en assurant un maintien mécanique renforcé.

Selon l'invention, ce but est atteint par la revendication 1 annexée.

**Description sommaire des dessins**

D'autres avantages et caractéristiques ressortiront plus clairement de la description qui va suivre de modes particuliers de réalisation de l'invention, donnés à titre d'exemples non limitatifs et représentés aux dessins annexés, dans lesquels :

Les figures 1 et 2 représentent un détecteur thermique selon l'art antérieur respectivement en vue de dessus et en coupe selon l'axe AA.
Les figures 3, 4, 6 et 7 représentent des modes de réalisation particuliers de l'invention.
La figure 5 illustre le mode de réalisation particulier représenté à la figure 4, en coupe selon l'axe BB.
La figure 8 montre un réseau de résistances, permettant d'estimer les pertes thermiques d'un détecteur selon l'invention par analogie avec un réseau de résistances électriques.

**Description de modes particuliers de réalisation.**

Les figures 3 à 6 montrent un détecteur thermique de rayonnement électromagnétique comportant une membrane 1 absorbante, fixée en suspension sur une face avant d'un substrat 2, sensiblement parallèlement au substrat 2, par des moyens de support isolant thermiquement la membrane 1 du substrat. Les moyens de support comportent, comme sur la figure 1, deux bras 3 d'isolation thermique, solidaires de la membrane 1 et fixés chacun sur un pilier 4 fin, et deux structures alvéolées. Chaque structure alvéolée est constituée par une paroi disposée dans un plan sensiblement perpendiculaire au substrat 2 et, ainsi, perpendiculaire à la membrane 1. Chaque structure alvéolée présente une pluralité d'orifices transversaux. Les bras 3 d'isolation thermique s'étendent le long de deux côtés opposés de la membrane et leur longueur correspond sensiblement à la dimension de la membrane. Chacune des structures alvéolées est disposée respectivement entre l'un des deux bras 3 et le substrat 2 et est en contact avec le bras 3 correspondant par au moins un point d'appui 5 (trois points d'appui sur la figure 3 et un point d'appui unique sur les autres figures). La structure alvéolée peut également être disposée entre la membrane 1 absorbante et le substrat 2, le long d'un bord de la membrane 1 absorbante.

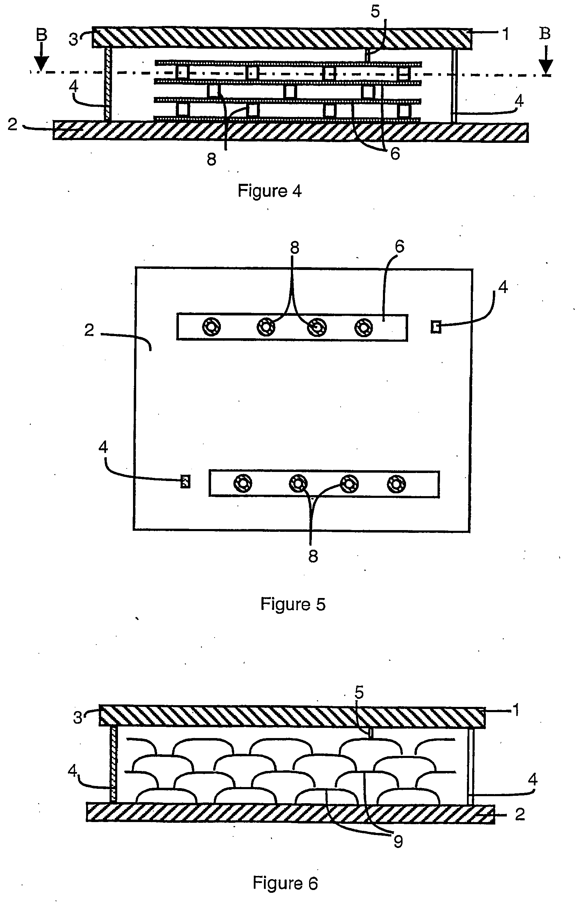

Les parois représentées aux figures 3 à 5 comportent chacune une pluralité de couches minces superposées 6, séparées par des entretoises 7 ou 8. Les entretoises représentées à la figure 3 sont constituées par des cloisons 7, perpendiculaires au substrat 2, tandis que les entretoises représentées aux figures 4 et 5 sont constituées par des cylindres 8 creux, également disposés perpendiculairement au substrat 2. La structure alvéolée peut revêtir différentes formes : parallélépipédique, comme représenté à la figure 3, pyramidale, pyramidale inverse, etc... La structure alvéolée peut être disposée à différents emplacements sous la structure suspendue, le long des bras 3 d'isolation thermique, comme représenté sur les figures 3 et 4, ou bien au contraire le long d'un côté de la membrane perpendiculaire aux bras 3. Ainsi, la zone située sous la membrane 1 reste libre de tout élément perturbateur susceptible de détériorer le fonctionnement d'une cavité interférentielle entre le substrat 2 et la membrane 1, réalisée par dépôt d'une couche réfléchissante sur le substrat sous la membrane 1 pour améliorer le taux d'absorption du détecteur.

La paroi représentée à la figure 6 comporte trois rangées superposées d'arcades 9 constituées par des couches minces, une première rangée d'arcades 9 étant disposée sur la face avant du substrat 2, chaque arcade d'une des rangées supérieures étant disposée sur les parties sommitales de deux arcades 9 adjacentes de la rangée inférieure.

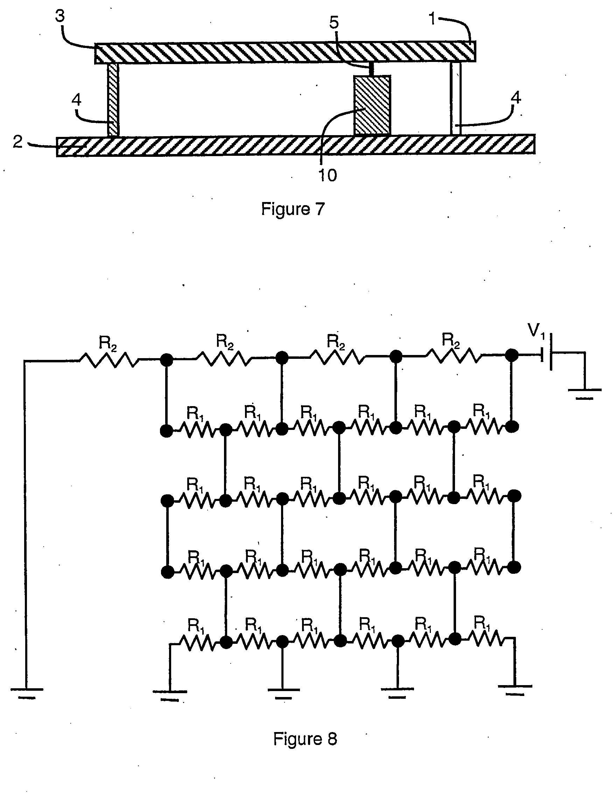

Dans une variante de l'invention, représentée à la figure 7, la structure alvéolée comporte un plot poreux 10, qui représente par nature une structure alvéolée. Différents matériaux peuvent répondre à cette application, en particulier les oxydes de silicium déposés par les techniques de sol gel, ou bien le silicium poreux obtenu par oxydation anodique en milieu HF du silicium cristallin et qui peut être rapporté sur le substrat 2 servant de support, préalablement à la construction des structures suspendues. Après dépôt, ou le cas échéant report du matériau poreux, la couche porteuse est délimitée par des procédés standard de photolithographie et de gravure afin de définir le plot 10.

Avantageusement, le substrat 2 est en silicium et peut comporter des dispositifs électroniques intégrés permettant de lire et de traiter le signal issu du thermomètre (non-représenté) positionné sur la membrane et mesurant l'élévation de la température de la membrane. Le thermomètre peut être, par exemple, un thermistor ou un capteur pyroélectrique, ferroélectrique ou thermoélectrique. Dans le cas particulier des thermistors, de nombreux matériaux peuvent convenir, notamment les semi-conducteurs, tels que le silicium ou le germanium, amorphe, polycristallin ou cristallin ; les oxydes de métaux, par exemple les oxydes de vanadium, les manganites ; les métaux à fort coefficient de température, par exemple les alliages à base de titane ou encore les alliages de Fe-Ni.

La membrane 1 peut être constituée par le matériau constituant le thermomètre lui-même ou par tout autre matériau, dont la chimie est compatible avec le matériau constituant le thermomètre, par exemple par des oxydes de silicium, des nitrures ou tout autre semi-conducteur diélectrique.

Les bras 3 d'isolation thermique peuvent être réalisés dans au moins un des matériaux qui constituent la membrane 1. Dans ce cas, et si la membrane comporte plusieurs couches suspendues, les bras 3 s'étendent comme un prolongement d'au moins une des couches formant la membrane. Afin d'assurer l'isolation thermique, les bras 3 peuvent être, par exemple, en oxyde de silicium, nitrure de silicium ou en silicium amorphe.

Outre leur rôle de maintien mécanique, les piliers 4 peuvent également assurer l'interconnexion électrique entre les électrodes du thermomètre, qui peuvent se prolonger le long des bras 3 d'isolation thermique, et les entrées de dispositifs électroniques de lecture et de traitement du signal qui sont disposés avantageusement sur le substrat 2 ou, éventuellement, sur une carte électronique disposée à proximité.

Les structures alvéolées soutiennent mécaniquement la membrane 1, apportant au moins un point d'appui 5, sans pour autant augmenter la conductance thermique des moyens de support. Le point ou les points d'appui 5 permettent la réalisation de bras 3 de section réduite, ce qui permet d'atteindre une isolation thermique plus élevée que dans l'art antérieur.

Une estimation du pouvoir d'isolation thermique des structures alvéolées permet de mettre en valeur les avantages de l'invention par rapport à l'art antérieur, en considérant un détecteur thermique carré de 25 μm de côté, correspondant aux dispositifs les plus avancés qui sont actuellement en cours de développement pour l'imagerie infrarouge. L'isolation thermique ultime ($R_{rad}$) d'un détecteur plan est plafonnée par les pertes radiatives qui dépendent à la fois de la surface ($S_D$) du détecteur et de sa température de fonctionnement (T) :

$$R_{rad} = \frac{1}{4(2S_D)\sigma T^3} \ ,$$

où σ est la constante de Stefan-Boltzmann.

A température ambiante et pour la taille du détecteur mentionné, l'isolation thermique ultime est théoriquement de 160 MK/W. L'isolation thermique d'un détecteur connu est inférieure car elle est réduite par les pertes thermiques par conduction dans les bras d'isolation thermique. Les valeurs usuelles sont comprises entre 5MK/W et 30 MK/W.

La résistance thermique de la structure alvéolée peut être modélisée par un réseau de résistances, représenté à la figure 8. Ce réseau est constitué d'une part de résistances $R_1$ qui représentent la structure alvéolée, et d'autre part des résistances $R_2$ qui correspondent à un des bras 3 d'isolation thermique. On considère une structure alvéolée à quatre niveaux constitués de couches d'oxyde de silicium de largeur de 1 μm et d'épaisseur de 6 nm, séparées les unes des autres par des cloisons verticales dont l'impédance thermique est négligée. Les cloisons verticales sont réparties uniformément au pas de 5 μm le long d'un même niveau et sont agencées en quinconce d'un niveau à l'autre. Le bras d'isolation thermique, de largeur de 1 μm, est constitué d'une couche de 20 nm d'oxyde de silicium et d'une couche de 5 nm de nitrure de titane. La longueur du bras d'isolation thermique est de 17 μm et il est constitué de quatre sections, l'extrémité de chacune venant prendre appui sur la structure alvéolée sous-jacente sur quatre points d'appui 5. Pour un détecteur comportant deux ensembles constitués chacun d'un bras d'isolation thermique et d'une structure alvéolée et compte tenu de la conductivité thermique des matériaux, on trouve une isolation thermique de 90 MK/W, soit trois fois supérieure à celle de l'art antérieur.

En diminuant le nombre de points d'appui 5, l'isolation thermique augmente légèrement. Par exemple, l'isolation thermique obtenue avec un seul point d'appui est de 98 MK/W, soit très proche du résultat obtenu avec quatre points d'appuis.

En diminuant le nombre de niveaux, l'isolation thermique diminue également. Par exemple, l'isolation thermique obtenue avec deux niveaux est de 72 MK/W. Une structure avec quatre niveaux correspond donc à un bon compromis pour un détecteur au pas de 25 μm, permettant d'améliorer sensiblement l'isolation thermique, tout en limitant le nombre d'opérations nécessaires à sa construction.

Un procédé de réalisation d'un détecteur selon l'invention comporte, avant réalisation de là membrane suspendue, la fabrication de la structure alvéolée.

Afin de réaliser la structure alvéolée représentée aux figures 4 et 5, constitué par des couches minces superposées 6, séparées par des cylindres 8 creux, on dépose, sur le substrat 2 ou sur une couche mince 6, et on recuit une couche sacrificielle constituée, par exemple, de polyimide. Puis on grave localement par photolithographie cette couche sacrificielle en réalisant un alignement de trous de diamètre de 1 μm qui traversent toute l'épaisseur de la couche sacrificielle. Ensuite on réalise le dépôt, par exemple par dépôt en phase vapeur, d'une couche diélectrique d'une épaisseur typique de 10 nm, qui recouvre la couche sacrificielle et qui tapisse les flancs et les fonds des trous de diamètre de 1 μm. Une étape suivante consiste à délimiter par photolithographie et gravure, l'étendue de la couche diélectrique pour définir la section de la paroi de la structure alvéolée. Ainsi, on obtient une première couche mince 6 disposée sur des cylindres 8 creux. Cette séquence d'opérations est ensuite répétée pour chaque couche mince 6 supplémentaire, en prenant soin de décaler les trous en quinconce d'un niveau à l'autre, par exemple en utilisant un jeu de masques adéquat. Le point d'appui 5 sur l'ensemble des couches minces est réalisé en suivant sensiblement les mêmes étapes. L'étape finale consiste à supprimer les couches sacrificielles, typiquement à l'aide d'une gravure sèche oxydante.

Afin de réaliser la structure alvéolée représentée à la figure 6, constituée par des arcades superposées constituées par des couches minces, on dépose et recuit également une couche sacrificielle. Le choix du matériau constituant la couche sacrificielle se porte sur un matériau qui présente une vitesse de gravure voisine de celle des résines photosensibles couramment utilisées, par exemple un polyimide. Ensuite, on dépose une résine photosensible dans laquelle on délimite, par exemple par insolation à travers un masque et développement photographique, des ouvertures de largeur adéquate débouchant sur la couche sacrificielle sous-jacente. On procède alors à un traitement thermique qui permet de faire fluer les flancs de la résine de manière. à leur conférer une forme d'arc de cercle. La gravure conjointe de la résine et de la couche sacrificielle permet ensuite, de manière connue, de reproduire les structures en arc de cercle dans la couche sacrificielle. Une étape suivante consiste à déposer une couche diélectrique, d'une épaisseur typiquement inférieure à 10 nm, recouvrant la couche sacrificielle et prenant appui sur le substrat sous-jacent aux endroits où la gravure de la couche sacrificielle a été totale. Ensuite, la largeur de la couche diélectrique est délimitée, par exemple à 1 $\mu$m, par photolithographie et gravure, de manière à former une rangée d'arcades 9. Comme dans le procédé précédent, la séquence des opérations est répétée pour chaque rangée d'arcades en décalant à chaque fois les arcades d'une demi-période par rapport aux arcades sous-jacentes.

## Revendications

1.  Détecteur thermique de rayonnement électromagnétique comportant une membrane (1) absorbante fixée en suspension sur une face avant d'un substrat (2), sensiblement parallèlement au substrat (2), par des moyens de support isolant thermiquement la membrane (1) du substrat (2) et comportant au moins une structure de support alvéolée s'étendant entre la face avant du substrat (2) et la membrane (1), sensiblement perpendiculairement à la face avant du substrat (2) et au plan de la membrane (1), détecteur **caractérisé en ce que** la structure alvéolée est constituée par une paroi présentant une pluralité d'orifices transversaux.

2.  Détecteur selon la revendication 1, **caractérisé en ce que** la structure de support alvéolée est reliée à la membrane (1) par un nombre restreint de points d'appui (5).

3.  Détecteur selon la revendication 2, **caractérisé en ce que** la structure de support alvéolée est reliée à la membrane (1) par un point d'appui (5) unique.

4.  Détecteur selon la revendication 2, **caractérisé en ce que** la structure de support alvéolée est reliée à la membrane (1) par trois points d'appui (5).

5.  Détecteur selon l'une quelconque des revendications 1 à 4, **caractérisé en ce que** la structure alvéolée est disposée entre la membrane (1) absorbante et le substrat (2), le long d'un bord de la membrane (1) absorbante.

6.  Détecteur selon l'une quelconque des revendications 1 à 5, **caractérisé en ce que** les moyens de support comportent au moins un bras (3) solidaire de la membrane (1) absorbante, chaque structure alvéolée étant disposée respectivement entre le bras (3) correspondant et le substrat (2).

7.  Détecteur selon l'une quelconque des revendications 1 à 6, **caractérisé en ce que** la paroi comporte une pluralité de couches minces (6) superposées, séparées par des entretoises.

8.  Détecteur selon la revendication 7, **caractérisé en ce que** les entretoises sont constituées par des cloisons (7) perpendiculaires au substrat (2).

9.  Détecteur selon la revendication 7, **caractérisé en ce que** les entretoises sont constituées par des cylindres (8) creux, disposés perpendiculairement au substrat (2).

10. Détecteur selon l'une quelconque des revendications 1 à 6, **caractérisé en ce que** la paroi comporte au moins deux rangées superposées d'arcades (9) constituées par des couches minces, une première rangée d'arcades (9) étant disposée sur la face avant du substrat (2), une arcade (9) d'une autre rangée étant disposée sur les parties sommitales de deux arcades (9) adjacentes de la rangée inférieure.

## Claims

1.  Thermal electromagnetic radiation detector comprising an absorbent membrane (1) fixed in suspension onto a front face of a substrate (2), in a direction substantially parallel to the substrate (2), by support means thermally insulating the membrane (1) from the substrate (2) and comprising at least one alveolate structure extending between the front face of the substrate (2) and the membrane (1), substantially perpendicularly to the front face of the substrate (2) and to the plane of the membrane (1), detector **characterized in that** the the alveolate structure is constituted by a wall presenting a plurality of transverse apertures.

2. Detector according to claim 1, **characterized in that** the alveolate structure is connected to the membrane (1) by a restricted number of bearing points (5).

3. Detector according to claim 2, **characterized in that** the alveolate structure is connected to the membrane (1) by a single bearing point (5).

4. Detector according to claim 2, **characterized in that** the alveolate structure is connected to the membrane (1) three bearing points (5).

5. Detector according to any one of claims 1 to 4, **characterized in that** the alveolate structure is arranged between the absorbent membrane (1) and the substrate (2), along one edge of the absorbent membrane (1).

6. Detector according to any one of claims 1 to 5, **characterized in that** the support means comprise at least one arm (3) fixedly secured to the absorbent membrane (1), each alveolate structure being respectively arranged between the corresponding arm (3) and the substrate (2).

7. Detector according to any one of claims 1 to 6, **characterized in that** the wall comprises a plurality of superposed thin layers (6) separated by spacers,

8. Detector according to claim 7, **characterized in that** the spacers are formed by partitions (7) perpendicular to the substrate (2).

9. Detector according to claim 7, **characterized in that** the spacers are formed by hollow cylinders (8) arranged perpendicularly to the substrate (2).

10. Detector according to any one of claims 1 to 6, **characterized In that** the wall comprises at least two superposed rows of arcades (9) formed by thin layers, a first row of arcades (9) being arranged on the front face of the substrate (2), an arcade (9) of another row being arranged on the top parts of two adjacent arcades (9) of the bottom row.

**Patentansprüche**

1. Thermischer Detektor zum Messen elektromagnetischer Strahlung, der eine absorbierende Membran (1) umfasst, die in Suspension an einer Vorderseite eines Substrats (2) im Wesentlichen parallel zum Substrat (2) befestigt ist, mittels Trägermitteln, welche die Membran (1) vom Substrat (2) thermisch isolieren und die mindestens eine wabenförmige Trägerstruktur aufweisen, die sich zwischen der Vorderseite des Substrats (2) und der Membran (1) erstreckt, und zwar im Wesentlichen quer zur Vorderseite des Substrats (2) und zur Ebene der Membran (1), Detektor, der **dadurch gekennzeichnet ist, dass** die wabenförmige Struktur von einer Wand gebildet wird, die eine Mehrzahl transversaler öffnungen aufweist.

2. Detektor nach Anspruch 1, **dadurch gekennzeichnet, dass** die wabenförmige Trägerstruktur über eine begrenzte Anzahl von Auflagepunkten (5) mit der Membran (1) verbunden ist.

3. Detektor nach Anspruch 2, **dadurch gekennzeichnet, dass** die wabenförmige Trägerstruktur über einen einzigen Auflagepunkt (5) mit der Membran (1) verbunden ist.

4. Detektor nach Anspruch 2, **dadurch gekennzeichnet, dass** die wabenförmige Trägerstruktur über drei Auflagepunkte (5) mit der Membran (1) verbunden ist.

5. Detektor nach einem der Ansprüche 1 bis 4, **dadurch gekennzeichnet, dass** die wabenförmige Struktur zwischen der absorbierenden Membran (1) und dem Substrat (2) entlang eines Rands der absorbierenden Membran (1) angeordnet ist.

6. Detektor nach einem der Ansprüche 1 bis 5, **dadurch gekennzeichnet, dass** die Trägermittel mindestens einen Arm (3) umfassen, der fest mit der absorbierenden Membran (1) verbunden ist, wobei jede wabenförmige Struktur jeweils zwischen dem entsprechenden Arm (3) und dem Substrat (2) angeordnet ist.

7. Detektor nach einem der Ansprüche 1 bis 6, **dadurch gekennzeichnet, dass** die Wand mehrere übereinander angeordnete Dünnschichten (6) umfasst, die durch Abstandshalter voneinander getrennt sind.

8. Detektor nach Anspruch 7, **dadurch gekennzeichnet, dass** die Abstandshalter von Trennwänden (7) gebildet werden, die quer zum Substrat (2) verlaufen.

9. Detektor nach Anspruch 7, **dadurch gekennzeichnet, dass** die Abstandshalter von Hohlzylindern (8) gebildet werden, die quer zum Substrat (2) angeordnet sind.

10. Detektor nach einem der Ansprüche 1 bis 6, **dadurch gekennzeichnet, dass** die Wand mindestens zwei übereinander angeordnete Reihen von Bögen (9) aufweist, die von Dünnschichten gebildet werden, wobei eine erste Reihe von Bögen (9) an der Vorderseite des Substrats (2) angeordnet ist, wobei ein Bogen (9) einer anderen Reihe über den Scheitelbereichen zweier angrenzender Bögen (9) der unteren Reihe angeordnet ist.

Figure 1 (Art antérieur)

Figure 2 (Art antérieur)

Figure 3

Figure 4

Figure 5

Figure 6

Figure 7

Figure 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6144030 A
- WO 03011747 A
- US 5656848 A